Europäisches Patentamt

European Patent Office

Office européen des brevets

(11) Numéro de publication : **0 076 737**
**B1**

(12) FASCICULE DE BREVET EUROPÉEN

(45) Date de publication du fascicule du brevet :
21.11.85

(51) Int. Cl.⁴ : **G 06 G 7/186, H 03 H 19/00**

(21) Numéro de dépôt : **82401754.5**

(22) Date de dépôt : **28.09.82**

(54) Intégrateur symétrique et application à un filtre.

(30) Priorité : 02.10.81 FR 8118637

(43) Date de publication de la demande :
13.04.83 Bulletin 83/15

(45) Mention de la délivrance du brevet :
21.11.85 Bulletin 85/47

(84) Etats contractants désignés :
DE FR GB IT NL

(56) Documents cités :
IEEE TRANSACTIONS ON CIRCUITS & SYSTEMS,
vol. CAS-27, no. 6, juin 1980, IEEE, pages 492-501,
New York, USA G.SZENTIRMAI et al: "Switched-
capacitor building blocks"
MICROELECTRONICS JOURNAL, vol. 11, no. 2,
mars/avril 1980, pages 13-21, Mackintosh Publications Ltd., Luton, G.B. R.GREGORIAN: "Filtering techniques with switched-capacitor circuits"
IEEE JOURNAL OF SOLID-STATE CIRCUITS, vol. SC-
15, no. 3, juin 1980, IEEE, pages 358-361, New York,
USA G.C. TEMES: "Finite amplifier gain and
bandwidth effects in switched-capacitor filters"
ELECTRONICS LETTERS, vol. 14, no. 12, 8 juin 1978,
pages 361-362, Hitchin Herts, G.B. G.C. TEMES: "The
derivation of switched-capacitor filters from active-
RC prototypes"
ELEKTROTECHNIK UND MASCHINENBAU, vol. 97,
no. 10, octobre 1980, pages 417-422, Vienne, AT. H.
WEINRICHTER: "Schalter-Kondensator-Filter: ein
neuer Weg zur Filterintergration"

(73) Titulaire : SOCIETE POUR L'ETUDE ET LA FABRICA-
TION DE CIRCUITS INTEGRES SPECIAUX - E.F.C.I.S.
17, avenue des Martyrs
F-38100 Grenoble (FR)

(72) Inventeur : Sokoloff, Boris
THOMSON-CSF SCPI 173, bld Haussmann
F-75379 Paris Cedex 08 (FR)

(74) Mandataire : Guérin, Michel et al
THOMSON-CSF SCPI 173, Bld Haussmann
F-75379 Paris Cédex 08 (FR)

## Description

La présente invention concerne le domaine du filtrage analogique et elle a pour objet la réalisation de filtres symétriques utilisant des amplificateurs symétriques.

Une des composantes essentielles des filtres est l'élément intégrateur qui était jusqu'à maintenant le plus souvent réalisé par un amplificateur opérationnel ayant deux entrées et une sortie : une entrée non inverseuse reliée à une masse du circuit et une entrée inverseuse qui d'une part reçoit un signal d'entrée à travers une résistance (ou un élément à caractéristique résistive formée par une capacité commutée) et d'autre part est reliée à la sortie de l'amplificateur opérationnel par une capacité d'intégration. L'entrée de signal et la sortie de signal se font par rapport à une masse.

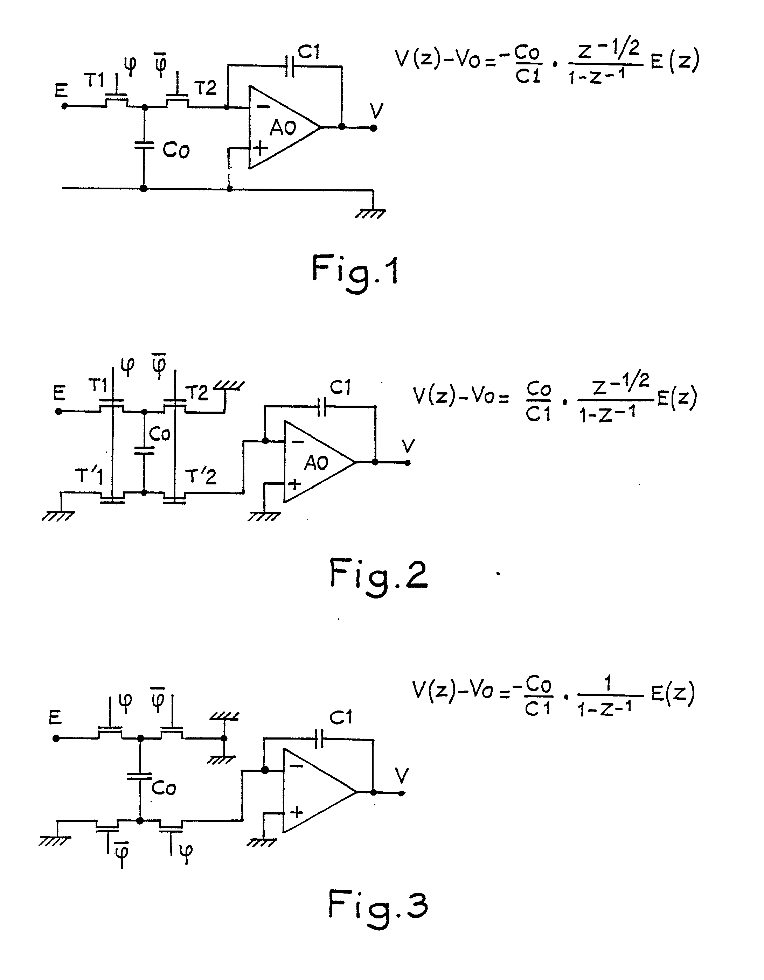

La figure 1 montre un exemple d'intégrateur ainsi réalisé avec un amplificateur opérationnel A0 bouclé par une capacité C1, avec une capacité d'entrée Co commutée par deux transistors MOS en série, T1 et T2, fonctionnant en opposition de phase. L'entrée de signal est désignée par E et la sortie par V.

La transformée en z de la fonction de transfert de ce circuit échantillonné est inscrite à côté du schéma de la figure 1. T est la période de commutation des transistors MOS T1 et T2 (qui sont rendus conducteurs alternativement mais jamais simultanément). Cette fonction de transfert présente un coefficient négatif $-$ Co/Cl et un numérateur en $z^{-1/2}$. Il s'agit bien d'une fonction d'intégration pure, mais ce type d'amplificateur est difficilement utilisable car il est beaucoup trop sensible aux capacités parasites.

Un autre exemple d'intégrateur qui, lui, est peu sensible aux capacités parasites, est représenté à la figure 2 : la capacité d'entrée Co peut être connectée par quatre transistors MOS T1, T'1, T2, T'2, d'abord entre la borne de signal E et la masse, puis entrée de l'amplificateur opérationnel et la masse, mais avec un signe inversé, pour réaliser la fonction de transfert indiquée à côté du schéma de la figure 2, qui est l'opposée de celle de la figure 1. Il s'agit bien encore d'une fonction d'intégration pure (ce que l'on voit par la présence du terme en $z^{-1/2}$), malheureusement, le coefficient de transfert est positif et il n'y a pas de moyen d'inverser son signe : on ne peut inverser les bornes d'entrée ou de sortie sans court-circuiter le signal utile.

On a donc proposé de réaliser le schéma de la figure 3 lorsqu'il y a besoin d'obtenir des fonctions de transfert d'intégration à coefficient négatif. La fonction de transfert obtenue est indiquée à côté du schéma de la figure 3. Ce circuit est peu sensible aux capacités parasites et il réalise bien un coefficient de transfert négatif. Malheureusement, il ne s'agit pas d'un intégrateur pur, comme le montre l'absence de terme en $z^{-1/2}$ au numérateur. Bien que le schéma de la figure 3 soit très proche de celui de la figure 2, puisqu'ils ne diffèrent que par le croisement des phases de commutation des transistors d'entrée, il n'est pas possible de les utiliser pour obtenir deux fonctions intégrales pures de signes opposés.

A ces inconvénients de circuits des figures 1 à 3, s'ajoute encore l'existence d'une diaphonie importante entre voies lorsque plusieurs filtres sont disposés côte à côte (par exemple intégrés sur un même substrat) ; cette diaphonie provient des sources d'alimentation qui sont communes, des horloges, de la transmission de signaux à travers le substrat, etc.

L'article de G. Temes « Finite Amplifier Gain and Bandwidth Effects in Switched-Capacitor Filters », paru dans IEEE Journal of Solid State Circuits, vol. SC-15 n° 3, décrit encore un autre exemple d'intégrateur présentant le même type d'inconvénient.

Enfin, dans la réalisation de filtres à partir d'intégrateurs, il est généralement utile de pouvoir créer des zéros de transmission dans la fonction de transfert du filtre, et un but de la présente invention est de réaliser un intégrateur qui, lorsqu'il est utilisé dans un filtre, permet facilement de créer des zéros de transmission pour obtenir les atténuations voulues en bande stoppée avec un nombre minimal de composants.

Pour atteindre ces différents buts, on propose, selon la présente invention, un intégrateur destiné à être utilisé dans un filtre qui comprend un amplificateur opérationnel à deux entrées dont l'une est inverseuse et l'autre non inverseuse, une capacité d'entrée commutée (Co) reliée par l'intermédiaire de deux premiers transistors à grille isolée (T3, T4) respectivement aux deux entrées de l'amplificateur opérationnel, les deux premiers transistors étant rendus conducteurs en phase l'un avec l'autre, deux autres transistors à grille isolée (T1, T2) étant prévus, également rendus conducteurs en phase l'un avec l'autre mais avec une phase disjointe de celle des deux premiers, ces deux autres transistors (T1, T2) reliant la capacité d'entrée (Co) à deux entrées différentielles (E1, E2) de l'intégrateur qui a par ailleurs pour sorties (V1, V2) les sorties de l'amplificateur opérationnel, une capacité de bouclage (C1) étant prévue entre une première sortie et une première entrée de l'amplificateur opérationnel, caractérisé en ce que :

l'intégrateur est symétrique,

l'amplificateur opérationnel a deux entrées flottantes et deux sorties flottantes,

une deuxième capacité de bouclage (C2) identique à la première, relie la deuxième entrée de l'amplificateur à la deuxième sortie.

On peut prévoir que l'intégrateur symétrique possède d'autres couples d'entrées ; dans ce cas, ces entrées sont reliées aux entrées de l'amplificateur opérationnel par un agencement à une capacité et quatre transistors à grille isolée, identique à l'agencement d'entrée des deux premières entrées.

2

De plus, et c'est là un des intérêts principaux de l'invention, on peut prévoir que l'intégrateur possède au moins un autre couple d'entrées reliées, par l'intermédiaire de capacités de liaison directe, mais sans transistors à grille isolée, aux deux entrées de l'amplificateur opérationnel.

Dans un filtre utilisant selon l'invention un tel intégrateur symétrique, ces capacités de liaison directe définiront par leur valeur des zéros de transmission de la fonction de transfert du filtre.

D'autres caractéristiques et avantages de l'invention apparaîtront à la lecture de la description détaillée qui suit et qui est faite en référence aux dessins annexés dans lesquels :

les figures 1 à 3 déjà décrites représentent des intégrateurs connus,

la figure 4 représente l'intégrateur symétrique selon l'invention,

la figure 5 représente un exemple de filtre selon l'invention réalisé avec des intégrateurs symétriques tels que celui de la figure 4.

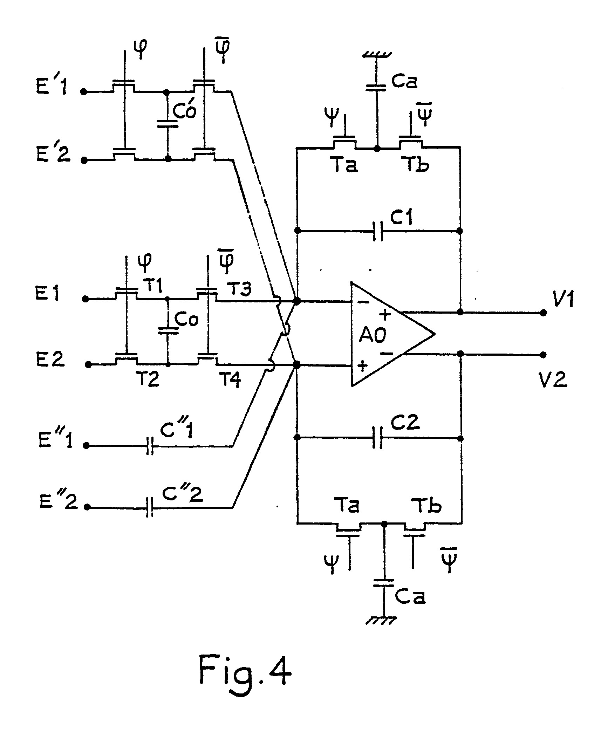

L'intégrateur symétrique de la figure 4 comporte plusieurs couples d'entrées, respectivement E1, E2 ; E'1, E'2 ; E"1, E"2, et un couple de sorties V1, V2.

En laissant d'abord de côté les entrées autres que E1 et E2, on voit que l'intégrateur comporte un amplificateur opérationnel A0 ayant une entrée inverseuse repérée par le signe − et une entrée non inverseuse repérée par le signe +. Ces entrées sont flottantes, c'est-à-dire que ni l'une ni l'autre n'est reliée à un potentiel fixe tel qu'une masse. De même, les deux sorties de l'amplificateur opérationnel, qui sont confondues avec les sorties V1 et V2 de l'intégrateur, sont flottantes.

Une capacité de bouclage C1 relie en permanence l'entrée inverseuse de l'amplificateur à la sortie V1, et une autre capacité C2, de même valeur, relie l'entrée non inverseuse à l'autre sortie V2.

Entre les entrées E1 et E2 de l'intégrateur et les entrées de l'amplificateur A0, on a prévu un agencement avec une capacité d'entrée Co et quatre transistors de commutation T1, T2, T3, T4 qui sont des transistors à grille isolée fabriqués selon une technologie MOS (métal-oxyde-semiconducteur) si l'intégrateur est formé sur un substrat semiconducteur selon cette technologie.

L'agencement d'entrée est le suivant : une première borne de la capacité Co est reliée d'une part à l'entrée E1 par l'intermédiaire du transistor T1 et d'autre part à l'entrée inverseuse de l'amplificateur A0 par l'intermédiaire du transistor T3. L'autre borne de la capacité est reliée d'une part à l'entrée E2 par l'intermédiaire du transistor T2 et d'autre part à l'entrée non inverseuse de l'amplificateur A0 par l'intermédiaire du transistor T4.

Les transistors T1 et T2 peuvent être rendus conducteurs simultanément, auquel cas la capacité Co est reliée entre les entrées E1 et E2, ou bloqués simultanément, auquel cas elle en est isolée. De même, les transistors T3 et T4 peuvent être rendus conducteurs simultanément, auquel cas la capacité Co est reliée entre les entrées de l'amplificateur opérationnel, ou bloqués simultanément, auquel cas elle en est isolée.

La commutation des transistors a lieu cycliquement à une fréquence fixe.

La phase de conduction des transistors T1 et T2 est en tous les cas disjointe de la phase de conduction des transistors T3 et T4, de sorte que les entrées E1 et E2 sont toujours isolées des entrées de l'amplificateur opérationnel.

La fonction de transfert en z de cet intégrateur, entre les entrées E1 et E2 et les sorties V1 et V2 s'écrit, si on appelle E(z) le signal appliqué entre les bornes E1 et E2, V(z) le signal de sortie entre les bornes V1 et V2, et V0 une valeur initiale de ce signal de sortie :

$$V(z) - Vo = - \frac{Co}{2C1} \cdot \frac{z^{-1/2}}{1-z^{-1}} \cdot E(z)$$

Il s'agit d'une fonction intégrale pure dont on peut changer le signe en croisant les entrées ou les sorties (puisque le signal d'entrée est pris flottant et non fixé par rapport à une masse).

A cette fonction on peut rajouter un deuxième terme similaire provenant de deux autres entrées E'1 et E'2 qui seraient couplées aux entrées de l'amplificateur opérationnel par un agencement à une capacité C'o et quatre transistors MOS tout à fait identique à l'agencement de Co, T1, T2, T3 et T4. On peut ainsi multiplier les couples d'entrées et obtenir une somme de fonctions intégrales de signaux distincts.

De plus, on peut rajouter à cette fonction de transfert un terme correspondant à un signal non intégré, ceci en prévoyant par exemple un couple d'entrées supplémentaires, E"1 et E"2, entre lesquelles est appliqué le signal à rajouter. L'entrée E"1 est reliée à l'entrée inverseuse de l'amplificateur A0 par une capacité C"1 de liaison directe (c'est-à-dire une capacité non commutée) ; de même, l'entrée E"2 est reliée à l'entrée non inverseuse par une capacité de liaison directe C"2 de même valeur. Ces capacités de liaison directe sont celles qui permettent, dans un filtre utilisant cet intégrateur symétrique, de créer des zéros de transmission.

L'intégrateur selon l'invention comprend encore de préférence des moyens de compensation de la tension de décalage (offset) de zéro de l'amplificateur opérationnel. Ces moyens peuvent être constitués par un élément à caractéristique résistive de forte valeur en parallèle sur chaque capacité de bouclage C1 et C2. Dans l'exemple représenté, cet élément est constitué par une capacité commutée Ca, reliée d'un côté à la masse et de l'autre côté à la fois à une borne de la capacité de bouclage C1 (ou C2) par l'intermédiaire d'un transistor Ta et à l'autre borne de cette capacité par l'intermédiaire d'un autre transistor Tb. Les transistors Ta et Tb sont commutés alternativement (phases de conduction disjointes) à une fréquence nettement plus faible que la fréquence de commutation des transistors d'entrée de l'intégrateur.

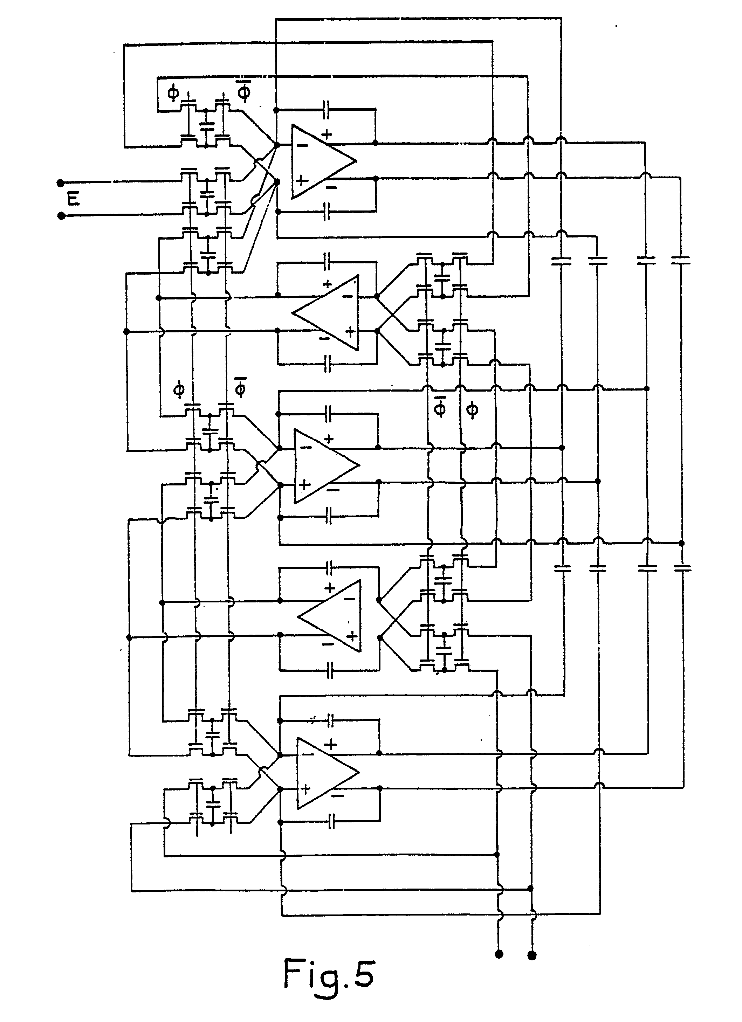

La figure 5 représente un schéma de filtre selon l'invention, utilisant cinq intégrateurs symétriques tels que celui de la figure 4 (les éléments de compensation d'offset n'ont pas été représentés).

Chaque intégrateur reçoit des signaux d'entrée différentiels à travers des capacités commutées ou à travers des capacités de liaison directe, ces signaux provenant des sorties différentielles des différents intégrateurs. Le filtre dessiné possède une fonction de transfert du cinquième ordre avec des zéros de transmission, et il réalise ainsi l'équivalent d'un filtre passe-bas purement réactif possédant deux circuits bouchons en série.

Dans l'ensemble des figures 1 à 5, on n'a pas représenté les moyens de commande de commutation périodique qui sont nécessaires pour rendre conducteurs ou bloquer les transistors d'entrée de l'intégrateur ou les transistors du montage de compensation d'offset.

## Revendications

1. Intégrateur destiné à être utilisé dans un filtre, comprenant un amplificateur opérationnel (A0) à deux entrées dont l'une est inverseuse et l'autre non inverseuse, une capacité d'entrée commutée (Co) reliée par l'intermédiaire de deux premiers transistors à grille isolée (T3, T4) respectivement aux deux entrées de l'amplificateur opérationnel, les deux premiers transistors étant rendus conducteurs en phase l'un avec l'autre, deux autres transistors à grille isolée (T1, T2) étant prévus, également rendus conducteurs en phase l'un avec l'autre mais avec une phase disjointe de celle des deux premiers, ces deux autres transistors (T1, T2) reliant la capacité d'entrée (Co) respectivement à deux entrées différentielles (E1, E2) de l'intégrateur qui a par ailleurs pour sorties (V1, V2) les sorties de l'amplificateur opérationnel, une capacité de bouclage (C1) étant prévue entre une première sortie et une première entrée de l'amplificateur opérationnel, caractérisé en ce que :
l'intégrateur est symétrique,
l'amplificateur opérationnel a deux entrées flottantes et deux sorties flottantes,
une deuxième capacité de bouclage (C2) identique à la première relie la deuxième entrée de l'amplificateur à la deuxième sortie.

2. Intégrateur symétrique selon la revendication 1 caractérisé par le fait qu'il possède au moins un autre couple d'entrées (E'1, E'2) reliées aux entrées de l'amplificateur opérationnel, par l'intermédiaire d'un agencement à une capacité et quatre transistors actionnés en phases deux à deux, identique à l'agencement d'entrée de deux entrées mentionnées en premier (E1, E2).

3. Intégrateur symétrique selon l'une des revendications 1 et 2 caractérisé par le fait qu'il possède au moins un couple d'entrées (E"1, E"2) reliées par l'intermédiaire de capacités non commutées (C"1, C"2) aux deux entrées de l'amplificateur opérationnel.

4. Intégrateur symétrique selon l'une des revendications 1 et 2 caractérisé par le fait qu'en parallèle sur chacune des deux capacités de bouclage est placé un élément de compensation de tension d'offset à caractéristique résistive.

5. Intégrateur symétrique selon la revendication 4 caractérisé par le fait que l'élément à caractéristique résistive est réalisé au moyen d'une capacité commutée (Ca) par deux transistors à grille isolée rendus conducteurs alternativement.

6. Filtre caractérisé par le fait qu'il comprend au moins un intégrateur selon l'une des revendications 1 à 5.

## Claims

1. Integrator for use in a filter, comprising an operational amplifier (A0) having two inputs one of which is inverting and the other of which is non inverting, a switched input capacity (Co) connected to the two inputs of the operational amplifier, resp., by two first insulated gate transistors (D3, D4) rendered conductive in phase with each other, two further insulated gate transistors (T1, T2) being provided which are likewise rendered conductive in phase with each other but with a phase different from that of the first two transistors, these two further transistors (T1, T2) connecting the input capacity (Co) to two differential inputs (E1, E2) of the integrator, resp., which is further provided with two outputs (V1, V2) which are the outputs of the operational amplifier, a looping capacity (C1) being provided between a first output and a first input of the operational amplifier, characterized in that
the integrator is symmetrical,
the operational amplifier has two floating inputs and two floating outputs,
a second looping capacity (C2) identical to the first connecting the second input of the amplifier to the second output.

2. Symmetrical integrator according to claim 1, characterized by the fact that it has at least a further

4

0 076 737

pair of inputs (E'1, E'2) coupled to the inputs of the operational amplifier through an arrangement having a capacity and four transistors controlled two by two in phase with each other, and identical to the input arrangement of the two first-mentioned inputs (E1, E2).

3. Symmetrical integrator according to any of claims 1 and 2, characterized by the fact that it has at least an input pair (E"1, E"2) connected to the two inputs of the operational amplifier through non-switched capacities (C"1, C"2).

4. Symmetrical integrator according to any of claims 1 and 2, characterized by the fact that an offset voltage compensation member having a resistive characteristic is mounted in parallel to each of the two looping capacities.

5. Symmetrical integrator according to claim 4, characterized by the fact that the member having a resistive characteristic is formed by means of a capacity (Ca) switched by two insulated gate transistors rendered conductive alternatively.

6. Filter, characterized by the fact that it comprises at least one integrator according to any of claims 1 to 5.


**Patentansprüche**

1. Integrator zur Verwendung in einem Filter, mit einem Operationsverstärker (A0), der zwei Eingänge aufweist, wovon einer invertiert und der andere nicht invertiert, mit einer geschalteten Eingangskapazität (Co), die über zwei erste Transistoren mit isoliertem Gate (T3, T4) mit dem einen bzw. anderen der zwei Eingänge des Operationsverstärkers verbunden wird, wobei die zwei ersten Transistoren gleichphasig miteinander leitend gemacht werden, und wobei zwei weitere Transistoren mit isoliertem Gate (T1, T2) vorgesehen sind, die ebenfalls gleichphasig miteinander leitend gemacht werden, jedoch mit anderer Phasenlage als die zwei ersten, wobei diese zwei weiteren Transisoren (T1, T2) die Eingangskapazität (Co) jeweils mit dem einen bzw. anderen der zwei differentiellen Eingänge (E1, E2) des Integrators verbinden, welcher ferner als Ausgänge (V1, V2) die Ausgänge des Operationsverstärkers aufweist, und wobei eine Rückschleifkapazität (C1) zwischen einem ersten Ausgang und einem ersten Eingang des Operationsverstärkers vorgesehen ist, dadurch gekennzeichnet, daß
der Integrator symmetrisch ist,
der Operationsverstärker zwei schwimmende Eingänge und zwei schwimmende Ausgänge aufweist,
eine zweite Rückschleifkapazität (C2), die gleich der ersten ist, den zweiten Eingang des Vertärkers mit dem zweiten Ausgang verbindet.

2. Symmetrischer Integrator nach Anspruch 1, dadurch gekennzeichnet, daß er wenigstens ein weiteres Paar von Eingängen (E'1, E'2) aufweist, die mit den Eingängen des Operationsverstärkers über eine Anordnung verbunden sind, die aus einer Kapazität und vier jeweils zu zweit in Phase gesteuerten Transistoren besteht und vollkommen gleich wie die Eingangsanordnung der zwei erstgenannten Eingänge (E1, E2) ausgebildet ist.

3. Symmetrischer Integrator nach Anspruch 1 oder 2, dadurch gekennzeichnet, daß er wenigstens ein Paar von Eingängen (E"1, E"2) aufweist, die über nicht geschaltete Kapazitäten (C"1, C"2) mit den zwei Eingängen des Operationsverstärkers verbunden sind.

4. Symmetrischer Integrator nach Anspruch 1 oder 2, dadurch gekennzeichnet, daß jeder der zwei Rückschleifkapazitäten ein Offsetspannungs-Kompensationselement mit resistiver Charakteristik parallel geschaltet ist.

5. Symmetrischer Integrator nach Anspruch 4, dadurch gekennzeichnet, daß das Element mit resistiver Charakteristik durch eine Kapazität (Ca) verwirklicht ist, die durch zwei Transistoren mit isoliertem Gate geschaltet wird, welche abwechselnd leitend gemacht werden.

6. Filter, dadurch gekennzeichnet, daß es wenigstens einen Integrator nach einem der Ansprüche 1 bis 5 enthält.

$$V(z) - V_0 = -\frac{C_0}{C_1} \cdot \frac{z^{-1/2}}{1-z^{-1}} E(z)$$

Fig.1

$$V(z) - V_0 = \frac{C_0}{C_1} \cdot \frac{z^{-1/2}}{1-z^{-1}} E(z)$$

Fig.2

$$V(z) - V_0 = -\frac{C_0}{C_1} \cdot \frac{1}{1-z^{-1}} E(z)$$

Fig.3

1

Fig.4

Fig.5